# EUROPÄISCHE PATENTANMELDUNG

(11) **EP 1 376 622 A2**
(43) Veröffentlichungstag der Anmeldung: **02.01.2004**
(21) Anmeldenummer: 03011330.2
(22) Anmeldetag: 19.05.2003
(51) Int. Cl.: H01C 1/08, H01C 1/082

(54) **Kühlkörper für einen Frequenzumrichter**

(30) Priorität: 22.05.2002 DE 10222471
(71) Anmelder: Lenze Drive Systems GmbH, 31855 Aerzen (DE)
(72) Erfinder: Borcherding, Holger, Dr., 31840 Hessisch Oldendorf (DE); Meyer, Thomas, 31787 Hameln (DE); Cavin, Pierre, 8570 Hard b. Weinfelden (CH); Hugentobler, Adrian, 8590 Romanshorn (CH); Jäckle, Benno, 3908 Lömmenschwil (CH)
(74) Vertreter: Elbertzhagen, Otto, Dipl.-Ing., Patentanwalt

(57) **Zusammenfassung**

Ein solcher Kühlkörper dient der Ableitung der Verlustwärme von Bauteilen des Frequenzumrichters, an dem ein drehzahlsteuerbarer Drehstrommotor mit einer Bremsschaltung betrieben ist, die einen Bremswiderstand benötigt. Zwecks vereinfachter Bauform erfüllt der Kühlkörper eine Doppelfunktion, indem er zusätzlich den Bremswiderstand aufnimmt und diesen mitkühlt.

## Beschreibung

Die Erfindung bezieht sich auf einen Kühlkörper für die Ableitung der Verlustwärme von Bauteilen eines Frequenzumrichters gemäß den Gattungsmerkmalen des Patentanspruchs 1.

Frequenzumrichter dienen vornehmlich zur Speisung von Drehstrommotoren mit einer variablen Frequenz, um entsprechend mit der Erzielung unterschiedlicher Drehfeldfrequenzen die Drehzahlen solcher Motoren steuern zu können. Bei bestimmten Antriebssystemen ist es erforderlich, über den Drehstrommotor eine Bremsung vornehmen zu können, wobei dann der im generatorischen Betrieb laufende Drehstrommotor eine elektrische Energie abgibt, die als anfallende Bremsenergie in geschalteten Widerständen, den Bremswiderständen, in Wärme umgesetzt wird. In solchen Fällen sind die Frequenzumrichter mit sogenannten Bremschoppern, nämlich mit Pulswiderständen, ausgestattet, deren Einbaulage unterschiedlich ist. Entweder sind sie innerhalb des Gehäuses des Frequenzumrichters untergebracht und werden hier durch einen internen Lüfter gekühlt. Oder in anderer Ausführung werden sie an dem vorhandenen Kühlkörper des Gerätes befestigt und sind somit durch die Belüftung des Kühlkörpers gekühlt. Unabhängig davon ist in allen bekannten Ausführungen der Bremswiderstand als separates, einzelnes Bauteil ausgeführt, das bei der Montage des Gerätes mitverbaut wird.

Des weiteren sind seit jüngerer Zeit Bauformen von elektrischen Widerständen bekannt, die ein als Strangprofil ausgebildetes, aus Aluminium bestehendes Gehäuse haben. Entsprechend dem gewünschten Widerstandswert wird ein solches Aluminiumprofil auf eine vorbestimmte Länge gesägt, womit sich ein stirnseitig offenes Aluminiumrohr ergibt. Darin wird der elektrische Widerstand in Gestalt einer Drahtwendel eingelegt und vergossen. Je länger das Rohr bemessen wird, umso mehr Widerstandsdraht ist darin unterzubringen und umso größer kann der Widerstandswert oder die Belastbarkeit des Widerstandes sein.

Die Erfindung beruht auf dem Gedanken, die Bauform solcher Widerstände und die Ausbildung eines für einen Frequenzumrichter bestimmten Kühlkörpers miteinander zu verbinden, um die Aufgabe zu lösen, einen Kühlkörper der eingangs genannten Art zu schaffen, der eine Doppelfunktion hat.

Diese Aufgabe wird bei einem Kühlkörper der gattungsbildenden Art nach der Erfindung durch die kennzeichnenden Merkmale des Patentanspruchs 1 gelöst.

Für den erfindungsgemäßen Kühlkörper ist von Bedeutung, daß er nicht nur die Funktion der Kühlung der für den Frequenzumrichter typischen Bauteile erfüllt sondern darüber hinaus den im Bedarfsfalle erforderlichen Bremswiderstand aufnimmt und diesen mitkühlt. In besonders vorteilhafter Ausführung besteht der Kühlkörper aus einem Aluminiumstranggußprofil, in das ein den Bremswiderstand aufnehmendes, längslaufendes Rohr so mit eingeformt ist, daß die Wandungen des Kühlkörpers, die vornehmlich die Kühlrippen bilden, zugleich als Wandungen für das den Bremswiderstand aufnehmenden Rohres genutzt sind.

Die Herstellung eines solchen Kühlkörpers erfolgt in gleicher Weise wie die der bekannten Widerstände durch Ablängen des Aluminiumprofils, womit zugleich die Konfiguration für den Kühlkörper vorgegeben ist, und durch Einlegen einer Drahtwendel in das in dem Kühlkörper gebildete Rohr, welches danach mittels einer geeigneten Masse vergossen wird. Für die Montage ergibt sich der Vorteil, daß mit dem Einbau des Kühlkörpers zugleich auch der Bremswiderstand montiert ist. In der Funktion ergibt sich noch die weitere Verbesserung, daß die vom Bremswiderstand abführbare Wärmeleistung höher gewählt werden kann als bei der herkömmlichen Anordnung, da auch für den Bremswiderstand die kühlende Oberfläche durch die Kühlrippen des Kühlkörpers vergrößert werden kann.

Die Erfindung wird nachfolgend anhand der Zeichnung an einem Ausführungsbeispiel noch näher erläutert. Dabei zeigen:
- Fig. 1: einen Querschnitt durch ein stranggepreßtes Aluminiumprofil zur Bildung eines Kühlkörpers für einen Frequenzumrichter,
- Fig. 2: eine der Fig. 1 entsprechende Darstellung, jedoch mit in dem Aluminiumprofil angebrachtem Bremswiderstand und
- Fig. 3: eine perspektivische Darstellung des mit dem Bremswiderstand ausgestatteten Kühlkörpers.

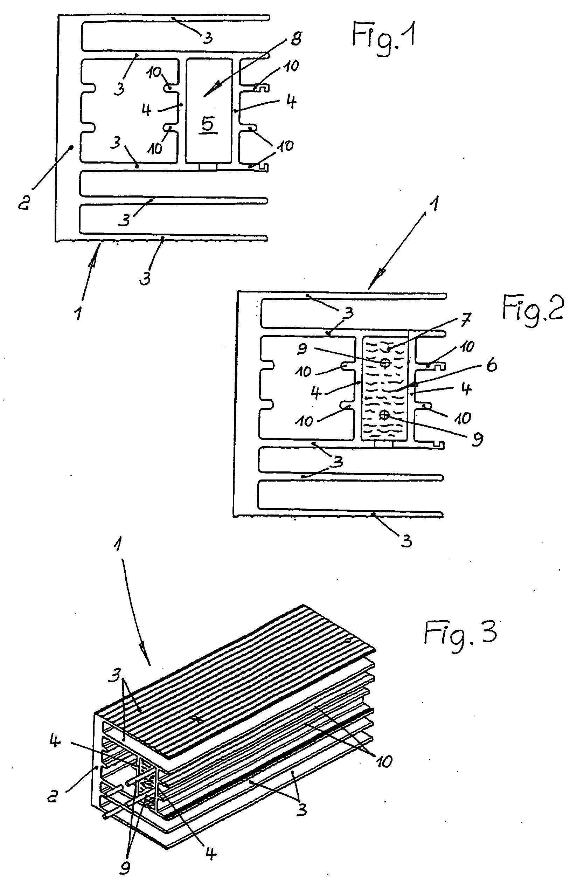

Fig. 1 zeigt im einzelnen ein Aluminiumstrangpreßprofil, welches einen Kühlkörper 1 für einen Frequenzumrichter bildet. Der Kühlkörper 1 besteht aus einer Grundplatte 2, die an einer ihrer Seiten im wesentlichen senkrecht abstehende Kühlrippen 3 aufweist. Zwischen zwei der Kühlrippen 3, die einen größeren Abstand als die übrigen Kühlrippen 3 voneinander haben, sind zwei im Abstand voneinander liegende Stege 4 eingeformt, die senkrecht zu den beiden Kühlrippen 3 verlaufen, mit denen sie einstückig ausgebildet sind. Von den beiden Stegen 4 und von den Abschnitten der beiden Kühlrippen 3, die sich zwischen den Stegen 4 erstrekken, wird ein im Kühlkörper 1 längslaufender, im Querschnitt rechteckiger Hohlraum umschlossen, der im folgenden als Rohr 5 bezeichnet ist. Mit dem Strangpressen des den Kühlkörper 1 bildenden Aluminiumprofils ist zugleich darin das Rohr 5 eingeformt, dessen Wandungen entsprechend durch die beiden Stege 4 und die erwähnten Abschnitte der Kühlrippen 3 gebildet sind. In der Ausgangslage ist an den beiden Stirnenden des Kühlkörpers 1 das Rohr 5 offen, die eine der beiden stirnseitigen Öffnungen 8 ist in Fig. 1 erkennbar.

In dem Rohr 5 des Kühlkörpers 1 wird ein Bremswiderstand 6 untergebracht, dessen wesentlicher Bestandteil ein Widerstandsdraht ist, der in Form einer Wendel, eines Mäanders oder dergleichen in das Rohr 5 des Kühlkörpers 1 eingebracht und darin mittels einer Vergußmasse 7 fixiert ist. Der Widerstandsdraht ist im einzelnen in der Zeichnung nicht wiedergegeben, weil er, soweit es insbesondere Fig. 2 betrifft, durch die Vergußmasse 6 verdeckt ist. Der elektrischen Verdrahtung des Bremswiderstandes 6 dienen aus der Vergußmasse 7 an einer der beiden Stirnseiten des Kühlkörpers 1 herausgeführte Anschlüsse 9.

Wie vor allem auch Fig. 3 veranschaulicht, haben die das Rohr 5 mit umgebenden Stege 4 an ihren von der Rohrinnenseite abliegenden Außenseiten gleichfalls als Kühlrippen fungierende Ansätze 10, womit eine besonders gute Wärmeabfuhr vom Bremswiderstand 6 gegeben ist.

## Patentansprüche

1. Kühlkörper für die Ableitung der Verlustwärme von Bauteilen eines Frequenzumrichters, an dem ein drehzahlsteuerbarer Drehstrommotor mit einer Bremsschaltung betrieben ist, für die ein Bremswiderstand vorgesehen ist,
**dadurch gekennzeichnet,**
**daß** der Bremswiderstand (5) in den Kühlkörper (1) integriert ist.

2. Kühlkörper nach Anspruch 1,
**dadurch gekennzeichnet,**
**daß** er aus einem Aluminiumstranggußprofil besteht, in das ein den Bremswiderstand (6) aufnehmendes, längslaufendes Rohr (5) eingeformt ist.

3. Kühlkörper nach Anspruch 2,
**dadurch gekennzeichnet,**
**daß** das eingeformte Rohr (5) einen quadratischen oder rechteckigen Querschnitt hat.

4. Kühlkörper nach Anspruch 2 oder 3,
**dadurch gekennzeichnet,**
**daß** das eingeformte Rohr von zwei von mehreren an einer Grundplatte (2) vorstehenden Kühlrippen (3) an einander begrenzt ist und zur Begrenzung an den weiteren Seiten des Rohres (5) diese Kühlrippen (3) miteinander mittels einander mit Abstand gegenüberliegender Stege (4) verbunden sind.

5. Kühlkörper nach Anspruch 4,
**dadurch gekennzeichnet,**
**daß** an den vom Rohrinnern abgewandten Seiten der Stege (4) zwischen den Kühlrippen (3 rippenförmige Ansätze (10) angeformt sind.

6. Kühlkörper nach einem der Ansprüche 1 - 5,
**dadurch gekennzeichnet,**
**daß** der Bremswiderstand (6) aus einem in dem in den Kühlkörper (1) eingeformten Rohr (5) mittels einer Vergußmasse (7) fixierten Widerstandsdraht besteht.

7. Kühlkörper nach Anspruch 6,
**dadurch gekennzeichnet,**
**daß** die Vergußmasse (7) die stirnseitigen Öffnungen (8) des Rohres (5) verschließt, wobei an einer dieser Öffnungen (8) die elektrischen Anschlüsse (9) für den Bremswiderstand (6) herausgeführt sind.
